# EUROPÄISCHE PATENTSCHRIFT

(11) **EP 0 427 222 B1**
(45) Veröffentlichungstag und Bekanntmachung des Hinweises auf die Patenterteilung: **09.07.1997**
(21) Anmeldenummer: 90121278.7
(22) Anmeldetag: 07.11.1990
(51) Int. Cl.: G03F 7/20

(54) **Vorrichtung zur Herstellung von Druckplatten**
Apparatus for the fabrication of printing plates
Appareil pour la fabrication de plaques d'impression

(30) Priorität: 10.11.1989 DE 3937557
(43) Veröffentlichungstag der Anmeldung: 15.05.1991
(73) Patentinhaber: Krause-Biagosch GmbH, D-33649 Bielefeld (DE)
(72) Erfinder: Fischer, Hermann, W-8900 Augsburg (DE); Heidenreich, Walter, W-4802 Halle/Westfalen (DE)
(74) Vertreter: Munk, Ludwig, Dipl.-Ing.

(56) Entgegenhaltungen:
- WO-A-89/02097
- DE-U- 8 813 594
- DE-U- 8 813 596
- FR-A- 2 273 307
- FR-A- 2 402 231
- US-A- 3 040 642
- US-A- 4 423 955

## Beschreibung

Die Erfindung betrifft eine Vorrichtung gemäß dem Oberbegriff des Anspruchs 1.

Eine Vorrichtung dieser Art ist aus der DE-U 88 13 594 bekannt. Bei dieser bekannten Anordnung ist die Kopierstation mit einem lediglich auf- und abbewegbaren Saugrahmen versehen, der zum Aufnehmen eines Films von der Filmkassette und zum Abgeben des Films von der Leerkassette unterfahren wird. Da hierbei kein Kopiervorgang stattfinden kann, bevor nicht der vorgesehene, eine Saugrahmen den alten Film abgegeben, einen neuen Film aufgenommen und auf den Plattenrohling abgesenkt hat, ergeben sich bei dieser bekannten Anordnung vergleichsweise große Abstände zwischen den aufeinanderfolgenden Kopiervorgängen. Es könnte zwar versucht werden, durch eine Erhöhung der Geschwindigkeit zu einer Erhöhung der Durchsatzleistung zu kommen. Mit einer Erhöhung der Geschwindigkeit erhöhen sich aber auch die Störanfälle sowie die Lärmentwicklung und die Verschleißgefahr.

Die FR-A 22 73 307 zeigt eine Vorrichtung zur Herstellung von Druckplatten mit einem unter einer Belichtungsstation durchlaufenden Transportband für aufeinanderfolgende Träger, in die jeweils eine Kopiervorlage und ein Film eingelegt sind. Das Einlegen erfolgt nicht in der Vorrichtung.

Hiervon ausgehend ist es daher die Aufgabe der vorliegenden Erfindung, bei einer Vorrichtung eingangs erwähnter Art den Abstand zwischen aufeinanderfolgenden Kopiervorgängen zu verkürzen und damit eine Steigerung der Produktion zu bewerkstelligen und dennoch eine schonende, störungsfreie und genaue Betriebsweise zu gewährleisten.

Diese Aufgabe wird erfindungsgemäß durch das Kennzeichen des Anspruchs 1 gelöst.

Die erfindungsgemäßen Maßnahmen stellen sicher, daß sich die bisher als reine Totzeiten in Erscheinung tretenden Be- und Entladezeiten und ein Kopiervorgang zumindest teilweise überschneiden können, indem der eine Saugrahmen be- bzw. entladen wird, während der auf dem anderen Saugrahmen aufgenommene Film kopiert wird und umgekehrt. Die Kopiervorgänge unter wechselweiser Verwendung des einen bzw. des anderen Saugrahmens können daher sehr schnell aufeinanderfolgen. Dennoch steht für die reinen Transportvorgänge vergleichsweise viel Zeit zur Verfügung, so daß die Bewegungsabläufe vergleichsweise langsam erfolgen können, was sich positiv auf die Störungssicherheit, die Lärmverminderung, die Verschleißvermeidung und Genauigkeit auswirkt. Ein weiterer Vorteil der erfindungsgemäßen Maßnahmen ist darin zu sehen, daß jeder Film von der Entnahme aus der Filmkassette bis zur Auslage in die Leerkassette auf dem jeweils zugeordneten Saugrahmen verbleibt. Dies ergibt nicht nur eine schonende und genaue Betriebsweise, sondern ermöglicht auch eine einfache Bauweise und vor allem eine hohe Arbeitsgeschwindigkeit. Hinzu kommt, daß Übergabevorgänge und die damit verbundenen Totzeiten in Wegfall kommen, was sich ebenfalls vorteilhaft auf die erzielbare Durchsatzleistung auswirkt.

Vorteilhafte Ausgestaltungen und zweckmäßige Fortbildungen der übergeordneten Maßnahmen sind in den Unteransprüchen angegeben und aus der nachstehenden Beispielsbeschreibung anhand der Zeichnung ersichtlich.

In der Zeichnung zeigen:
- Figur 1: eine schematische Darstellung einer erfindungsgemäßen Kopiermaschine mit zwei reversierend bewegbaren Saugrahmen,
- Figur 2: einen Schnitt durch einen Rahmenhalter der Anordnung nach Figur 1,
- Figur 3: eine Draufsicht auf den Rahmenhalter nach Figur 1,
- Figur 4: ein Beispiel für eine Schleppeinrichtung der Anordnung nach Figur 1,
- Figuren 5a-5e: ein Funktionsschema der Anordnung nach Figur 1 und
- Figur 6: eine schematische Draufsicht auf ein Ausführungsbeispiel mit nebeneinander verlaufenden Fahrstraßen für die Saugrahmen.

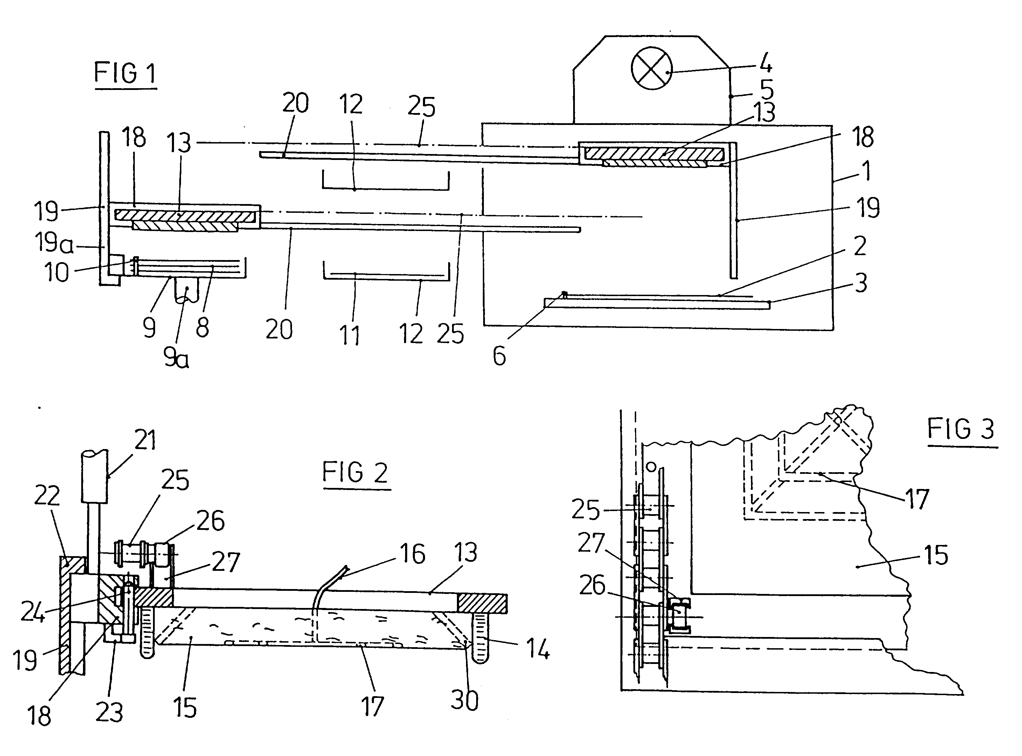

Die der Figur 1 zugrundeliegende Kopiermaschine enthält eine in einem Gehäuse untergebrachte Kopierstation 1 mit einem mit jeweils einem Plattenrohling 2 beschickbaren Plattentisch 3 und einer diesem zugeordneten Belichtungseinrichtung 4. Die durch eine Lampe gebildete Belichtungseinrichtung 4 ist in einem mit Abstand oberhalb des Plattentischs 3 angeordneten Belichtungskopf 5 aufgenommen. Dieser bildet hier einen stationären Teil des die Kopierstation 1 enthaltenden Gehäuses. Der Plattentisch 3 ist in an sich bekannter Weise parallel zu sich in X- und Y-Richtung verfahrbar. Der auf dem Plattentisch 3 aufnehmbare Plattenrohling 2 ist registergenau positioniert, wie durch einen Registerstift 6 angedeutet ist.

Auf den Plattenrohling 2 wird das Druckbild aufkopiert. Hierzu werden etwa seitengroße Filme nacheinander auf die jeweils zugeordnete Stelle des Plattenrohlings 2 aufgelegt und durch entsprechende Belichtung mittels der Belichtungseinrichtung 4 aufkopiert. Die noch nicht kopierten Filme 8 werden dabei in der richtigen Reihenfolge in Form eines Stapels bereitgehalten, zu dessen Aufnahme eine außerhalb der Kopierstation 1 angeordnete Filmkassette 9 vorgesehen ist. In dieser sind die Filme 8 registergenau positioniert, wie durch einen Registerstift 10 angedeutet ist. Die bereits kopierten Filme 11 werden in Leerkassetten 12 abgeworfen, die sich im Bereich zwischen der Kopierstation 1 und der Filmkassette 9 befinden.

Zum Transport der Filme vom durch die Kassetten 9, 11 gebildeten Filmlager in die Kopierstation 1 und zurück sind hier zwei Saugrahmen 13 vorgesehen, deren Arbeitskreisläufe so gegeneinander verschoben sind, daß sich, wie dargestellt, der eine Saugrahmen in der Kopierstation 1 befinden kann, während sich der andere Saugrahmen im Bereich der Filmkassette 9 befinden kann und umgekehrt. Die Saugrahmen 13 enthalten, wie am besten aus Figur 2 erkennbar ist, eine durch eine umlaufende, elastische Dichtung 14 begrenzte Platte 15, die mit über eine Vakuumleitung 16 an eine Vakuumquelle anschließbaren, oberflächenseitig offenen Kanälen 17 versehen ist. Durch Beaufschlagung der Kanäle 17 mit Vakuum ist es möglich, jeweils einen Film an die Platte 15 anzusaugen und an dieser zu halten. Die Platte 15 ist lichtdurchlässig.

Zur Entnahme eines Films aus der Filmkassette 9 bzw. zum Auflegen eines Films auf den Plattenrohling 3 wird der betreffende Saugrahmen 13 in Wirkverbindung mit der Filmkassette 9 bzw. dem Plattentisch 3 gebracht. Um dabei eine hohe Exaktheit zu gewährleisten, sind der Filmkassette 9 bzw. der Kopierstation 1 zugeordnete Rahmenhalter 18 vorgesehen, in welche jeweils der mit der Filmkassette 9 bzw. mit dem Plattentisch 3 in Wirkverbindung zu bringende Saugrahmen 13 eingefahren wird. Die Rahmenhalter 18 werden parallel zur Achse der Belichtungseinrichtung 4 auf- und abbewegt.

Der innere, dem Plattentisch 3 zugeordnete Rahmenhalter 18 kann dabei zur Erzielung einer stationären Anordnung des Plattentisches 3 von beiden Saugrahmenfahrstraßen aus bis auf den Plattentisch 3 abgesenkt werden. Dasselbe ist im Bereich der Filmkassette 9 möglich. Hier soll der äußere, der Filmkassette 9 zugeordnete Rahmenhalter 18 nur zwischen den beiden Saugrahmenfahrstraßen auf- und abbewegbar sein. Dafür ist die Filmkassette 9 so heb- und senkbar, daß ihr Filmstapel in und außer Eingriff mit dem in den äußeren Rahmenhalter 18 eingefahrenen Saugrahmen 13 bringbar ist, der dabei mittels des Rahmenhalters 18 in eine Warteposition auf dem Niveau der unteren Saugrahmenfahrstraße gehalten wird. Der Hub der Filmkassette 9 ist ist, daß die Abnahme der Filmstapelhöhe ausgelichen wird.

Zur Führung der Rahmenhalter 18 bzw. Filmkassette 9 sind belichtungsachsparallele Vertikalführungen 19 bzw. 19a vorgesehen. Der Filmkassette 9 ist eine Hubeinrichtung 9a zugeordnet. Die den Rahmenhaltern 18 zugeordneten Hubeinrichtungen sind in Figur 2 bei 21 angedeutet.

Zur Aufnahme der Saugrahmen 13 auf dem Weg zwischen den Rahmenhaltern 18 sind deckend übereinander angeordnete, quer zur Belichtungsachse verlaufende Längsführungsbahnen 20 vorgesehen. Jedem Saugrahmen 13 ist eine eigene Längsführungsbahn 20 zugeordnet. Im dargestellten Ausführungsbeispiel ergeben sich dementsprechend zwei übereinander angeordnete Längsführungsbahnen 20, auf denen der jeweils zugeordnete Saugrahmen 13 reversierend hinund herverschiebbar ist. Die die Längsführungsbahnen 20 bildenden Schienen enden einerseits innerhalb der Kopierstation 1 und andererseits im Bereich neben der Filmkassette 9 jeweils fluchtend mit den einander zugewandten Flanken der Rahmenhalter 18, so daß diese entlang ihrer Vertikalführungen 19 quer zu den Längsführungsbahnen 20 bewegbar sind. Das Führungsprofil der die Längsführungsbahnen 20 bildenden Schienen und der Rahmenhalter 18 ist dabei identisch, so daß sich ein stufenloser übergang ergibt, sofern sich ein Rahmenhalter 18 auf der Höhe einer Längsführungsbahn 20 befindet, was das Einfahren der Saugrahmen 13 in die Rahmenhalter 18 erleichtert. Die Rahmenhalter 18 und die die Längsführungsbahnen 20 bildenden Schienen können dabei einfach mit stumpfen Stoß unter Einhaltung des erforderlichen Bewegungsspiels für die Rahmenhalter 18 aneinander anschließen.

Die Rahmenhalter 18 sind jeweils, wie die Figur 2 weiter erkennen läßt, mittels einer schon erwähnten Antriebseinrichtung 21 bewegbar, die hier als Zylinder-Kolbenaggregat ausgebildet sein kann. Diese Antriebseinrichtungen 21 sind dabei so gesteuert, daß die Rahmenhalter 18 jeweils auf der Höhe der beiden Längsführungsbahnen 20 angehalten werden können, um den betreffenden Saugrahmen 13 ein- bzw. ausfahren zu können. Die mit den Längsführungsbahnen 20 fluchtenden Haltestellen der Rahmenhalter 18 können dabei im durch im Bereich ihrer Vertikalführungen 19 angeordnete Rastelemente definiert sein, wie in Figur 2 durch einen Anschlag 22 angedeutet ist. Der in einen Rahmenhalter 18 jeweils eingefahrene Saugrahmen 13 wird auf dem betreffenden Rahmenhalter 18 registergenau arretiert. Hierzu sind die Rahmenhalter 18, wie Figur 2 weiter erkennen läßt, mit entsprechenden Arretierungseinrichtungen versehen, die hier durch einen mittels einer zugeordneten Stelleinrichtung 23 betätigbaren Registerstift 24 angedeutet sind.

Jeder Längsführungsbahn 20, die jeweils einem Saugrahmen 13 zugeordnet ist, ist eine Leerkassette 12 zugeordnet. Im dargestellten Ausführungsbeispiel sind dementsprechend zwei Leerkassetten 12 vorgesehen, die jeweils unterhalb der jeweils zugeordneten Längsführungsbahn 20 stationär angeordnet sind. Die in die Leerkassetten 12 jeweils einzulegenden Filme 11 werden vom darüber hinweggehenden Saugrahmen 13 im Vorbeigang abgeworfen, indem einfach das am betreffenden Saugrahmen 13 anliegende Vakuum abgeschaltet wird. Denkbar wäre selbstverständlich auch, die Saugrahmen 13 zum Abwerfen der kopierten Filme 11 oberhalb der betreffenden Leerkassette 12 kurz anzuhalten und/oder mit Blasluft zu beaufschlagen. Die Filmkassette 9 ist in Richtung der Führungsbahnen 20 gegenüber der benachbarten Leerkassette 12 so weit nach außen versetzt, daß sie sich jenseits des äusseren Endes der Längsführungsbahnen 20 befindet.

Sofern die hier vorgesehene, eine Filmkassette 9 stationär angeordnet ist, kann diese sich auf dem Niveau der unteren Leerkassette 12 befinden. Die dem äußeren Rahmenhalter 18 zugeordnete Vertikalführung reicht dabei so weit über die untere Längsführung 20 hinaus, daß der zugeordnete, äußere Rahmenhalter 18 von seinen Haltestellen im Bereich der beiden Längsführungsbahnen 20 aus auf die darunter sich befindende, stationäre Filmkassette 9 absenkbar ist. Hier ist die Filmkassette 9 jedoch, wie schon erwähnt, zwecks einfachen Ausgleichs der Abnahme der Filmstapelhöhe von ihrer auf dem Niveau der internen Leerkassette 12 sich befindenden unteren Führungsbahn 20 absenkbaren, d.h. in jedem Falle dort wartenden äußeren Rahmenhalter 18 anhebbar. Die dem äußeren Rahmenhalter 18 zugeordnete Vertikalführung 19 reicht dementsprechend nur über den Bereich zwischen den beiden Führungsbahnen 20. An diese Vertikalführung 19 kann die der Filmkassette 9 zugeordnete Vertikalführung 19a nach unten anschließen. Die dem inneren Rahmenhalter 18 zugeordnete Vertikalführung 19 reicht bis in den Bereich des Plattentisches 3 herab, so daß der betreffende Rahmenhalter 18 bis auf den in vertikaler Richtung stationär angeordneten Plattentisch absenkbar ist. Anstelle dieser Vertikalbewegbarkeit des inneren Rahmenhalters 18 könnte, wie schon erwähnt, auch der Plattentisch 3 so heb- und senkbar angeordnet sein, daß er mit jedem der auf unterschiedlichen Niveau hin- und herbewegbaren und in den inneren Rahmenhalter 18 eingefahrenen Saugrahmen 13 in Wirkverbindung bringbar ist.

Zum Verschieben der Saugrahmen 13 entlang der jeweils zugeordneten Längsführungsbahn 20 ist jeder Längsführungsbahn 20 eine in Figur 1 durch strichpunktierte Linien angedeutete Schleppeinrichtung 25 zugeordnet, mit welcher der jeweils zugeordnete Saugrahmen 13 so kuppelbar ist, daß er in Längsrichtung der Längsführungsbahnen 20 mitgenommen und durch vertikale Bewegung einbzw. ausgekuppelt werden kann. In der in einen Rahmenhalter 18 eingefahrenen Endstellung läßt sich dementsprechend durch entsprechende Vertikalbewegung des Rahmenhalters 18 eine automatische Entkupplung bzw. Einkupplung des Saugrahmens 13 mit der jeweils zugeordneten Schleppeinrichtung 25 bewerkstelligen. Die Schleppeinrichtung 25 kann, wie in den Figuren 2 und 3 dargestellt ist, durch längsführungsparallele Schleppketten gebildet werden, an denen jeweils seitlich abstehende Mitnehmerrollen 26 befestigt sind. Die Saugrahmen 13 sind mit vertikal verlaufenden Mitnehmerleisten 27 versehen, die einen hier nach oben offenen Schacht für jeweils eine Mitnehmerrolle 26 bilden. Im Falle einer Vertikalbewegung des Rahmenhalters 18 samt hierauf aufgenommenem Saugrahmen 13 bewegt sich die Mitnehmerrolle 26 innerhalb des durch die rahmenfesten Mitnehmerleisten 27 gebildeten Schachts bzw. taucht aus diesem aus und ein. Im Falle einer Längsbewegung der Schleppeinrichtung 25 wird der Saugrahmen 13 über seine im Eingriff mit einer Mitnehmerrolle 26 stehenden Mitnehmerleisten 27 in Längsrichtung mitgenommen. Um Kollisionen der Rahmenhalter 18 mit den Schleppeinrichtungen 25 zu vermeiden, kann die untere Schleppeinrichtung gegenüber der oberen Schleppeinrichtung parallel zur Längsrichtung der Längsführungsbahnen 20 nach außen versetzt sein.

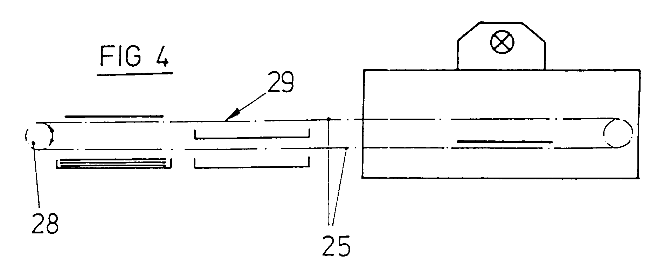

Die den übereinander angeordneten Längsführungsbahnen 20 jeweils zugeordneten Schleppeinrichtungen 25 können als voneinander unabhängige Zugorgane ausgebildet sein, die separat voneinander bewegbar sind. Insbesondere im Falle von lediglich zwei Saugrahmen 13 lassen sich deren Arbeitskreisläufe jedoch ohne weiteres so gegeneinander verschieben, daß sich gleichzeitig, gegenläufige Bewegungen der Saugrahmen 13 im Bereich der Längsführungsbahnen 20 ergeben. In einem derartigen Fall kann zur Bildung der beiden Schleppeinrichtungen 25, wie Figur 4 zeigt, einfach ein endloses, über zwei Umlenkorgane 28 umgelenktes Zugorgan 29 Verwendung finden, dessen Obertrum die der oberen Längsführungsbahn 20 zugeordnete Schleppeinrichtung und dessen Untertrum die der unteren Längsführungsbahn 20 zugeordnete Schleppeinrichtung bildet. Eines der Umlenkorgane 28 wird hierbei einfach reversierend angetrieben, so daß sich die gewünschte hinund hergehende Bewegung der Schleppeinrichtungen 25 ergibt.

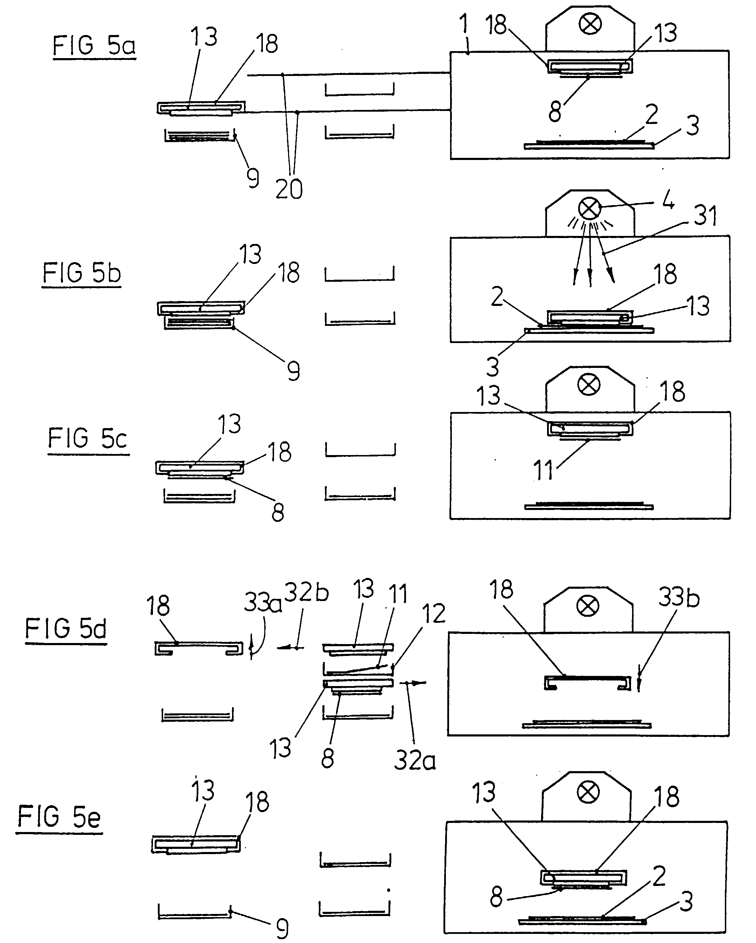

Die Arbeitsweise einer erfindungsgemäßen Kopiermaschine ist am besten aus den Figuren 5a bis 5e erkennbar, wobei in diesem Zusammenhang eine Ausführung mit stationärer Filmkassette 9 zugrundeliegt. Der Figur 5a liegt die Situation zugrunde, in der sich der äußere Rahmenhalter 18 in der mit der unteren Längsführungsbahn 20 fluchtenden Haltestelle und der innere Rahmenhalter 18 in der mit der oberen Längsführungsbahn 20 fluchtenden Haltestelle befinden. In den inneren Rahmenhalter 18 ist der der oberen Längsführungsbahn 20 zugeordnete Saugrahmen 13 eingefahren, der einen vorher au sder Filmkassette 9 entnommenen Film 8 trägt. In den äußeren Rahmenhalter 18 ist der der unteren Längsführungsbahn 20 zugeordnete Saugrahmen 13 eingefahren, der hier noch keinen Film trägt. Anschließend wird durch den im äußeren Rahmenhalter 18 aufgenommenen Saugrahmen 13 ein Film aus der Filmkassette 9 aufgenommen. Gleichzeitig wird der auf dem auf dem inneren Rahmenhalter 18 aufgenommenen Saugrahmen 13 gehaltene Film 8 auf den auf dem Plattentisch 3 aufliegenden Plattenrohling 2 aufkopiert. Hierzu werden, wie aus Figur 5b ersichtlich ist, die Rahmenhalter 18 samt hierin jeweils aufgenommenen Saugrahmen 13 auf die Filmkassette 9 bzw. den Plattentisch 3 abgesenkt. Zur Aufnahme eines Films aus der Filmkassette 9 wird dabei der im äußeren Rahmenhalter 18 aufgenommene Saugrahmen 13 mit Vakuum beaufschlagt. Der auf dem auf dem inneren Rahmenhalter 18 aufgenommenen Saugrahmen 13 gehaltene Film wird zum Kopieren an den Plattenrohling 2 angesaugt. Hierzu sind, wie am besten aus Figur 2 erkennbar ist, im Bereich der umlaufenden Dichtung 14 ausmündende Saugkanäle 30 vorgesehen, die zum Ansaugen des Films an den Plattenrohling 2 mit Vakuum beaufschlagt werden, wobei in an sich bekannter Weise zunächst ein schwächeres Vorvakuum und dann das Hauptvakuum aufgebaut werden. Hierdurch wird der von der umlaufenden Dichtung 14 randseitig begrenzte Raum zwischen der Platte 15 und dem Plattenrohling 2 evakuiert, wodurch sich die Platte 15 mit dem hieran gehaltenen Film unter entsprechender Verformung der Dichtung 14 an den Plattenrohling 2 anlegt. Anschließend erfolgt die Belichtung des Films durch entsprechende Aktivierung der Belichtungseinrichtung 4, wie in Figur 5b durch Lichtstrahlen 31 angedeutet ist.

Im nächsten Schritt kehrt, wie in Figur 5c dargestellt ist, der äußere Rahmenhalter 18 zusammen mit dem auf ihm arretierten, nun einen Film 8 tragenden Saugrahmen 13 in die mit der unteren Längsführungsbahn 20 fluchtende Stellung zurück. Der innere Rahmenhalter 18 kehrt mit dem auf ihm arretierten Saugrahmen, der den nun bereits kopierten Film trägt, in die mit der oberen Längsführungsbahn 20 fluchtende Stellung zurück. Zum Lösen des Films vom Plattenrohling 20 wird das über die Kanäle 30 anliegende Vakuum vor dem entsprechenden Hub des inneren Rahmenhalters 18 abgebaut. Anschließend erfolgt, wie Figur 5d zeigt, ein Stellungswechsel der Saugrahmen 13, wobei der der unteren Längsführungsbahn zugeordnete untere Saugrahmen 13, der nun einen neuen Film 8 trägt, vom Bereich der Filmkassette 9 in die Kopierstation 1 verbracht wird und gegenläufig dazu der der oberen Längsführungsbahn 20 zugeordnete, obere Saugrahmen 13, der den vorher kopierten Film 11 trägt, aus der Kopierstation 1 entfernt wird, wie in Figur 5d durch die Richtungspfeile 32a, 32b angedeutet ist. Gleichzeitig gehen die leeren Rahmenhalter 18 in vertikaler Richtung in die jeweils andere Haltestelle, d. h. im vorliegenden Fall bewegt sich der äußere Rahmenhalter 18 in die mit der oberen Längsführungsbahn 20 fluchtende Haltestelle und der innere Rahmenhalter 18 bewegt sich in die mit der unteren Längsführungsbahn 20 fluchtende Haltestelle, wie in Figur 5d durch die Richtungspfeile 33a, 33b angedeutet ist. Die Rahmenhalter 18 nehmen dementsprechend eine Position ein, in der die auf den Längsführungsbahnen 20 ankommenden, gemäß Richtungspfeilen 32a, 32b sich bewegenden Saugrahmen 13 aufgenommen werden können. Diese Situation liegt der Figur 5e zugrunde. Beim Vorbeigang des den kopierten Film 11 tragenden, oberen Saugrahmens 13 an der zugeordneten Leerkassette 12 wird das an diesem Saugrahmen 13 anliegende Vakuum abgeschaltet, womit der Film 11 in die der oberen Längsführungsbahn 20 zugeordnete Leerkassett 12 abgeworfen wird.

Sobald die Saugrahmen 13, wie in Figur 5e gezeigt, in den die zugeordnete Position einnehmenden Rahmenhalter 18 eingefahren sind, können sich die Entnahme eines Films aus der Filmkassette 9 und der Kopiervorgang wiederholen, wobei nun der der oberen Längsführungsbahn zugeordnete Saugrahmen 13 einen neuen Film 8 aus der Filmkassette 9 holt und umgekehrt der auf dem der unteren Längsführungsbahn 20 zugeordneten Saugrahmen 13 aufgenommene Film auf den Plattenrohling 2 aufkopiert wird. Jeder Saugrahmen 13 vollführt, wie die Darstellung gemäß Figuren 5a bis 5e zeigt, einen Arbeitskreislauf, der praktisch bei der Entnahme eines neuen Films 8 aus der Filmkassette 9 beginnt und dort praktisch auch wieder endet, nachdem vorher der Kopiervorgang erfolgt ist und der kopierte Film anschließend in die Leerkassette abgegeben wurde. Die Arbeitskreisläufe der beiden Saugrahmen 13 sind hier um etwa einen halben Kreislauf phasenverschoben. Dementsprechend befindet sich, wie die Figuren 5a bis 5c zeigen, jeweils ein Saugrahmen 13 im Kopierbereich, während der jeweils andere Saugrahmen 13 sich außerhalb hiervon befindet und umgekehrt. Lediglich beim Stellungswechsel begegnen sich die beiden Saugrahmen 13, wie Figur 5d zeigt, wobei gleichzeitig die in dieser Situation geräumten Rahmenhalter in die jeweils neue Position gehen können. Infolge der Mehrzahl der vorgesehenen Saugrahmen 13 und der gegenseitigen Phasenverschiebung ihrer Arbeitskreisläufe ergibt sich zwangsläufig ein kurzer Abstand zwischen aufeinanderfolgenden Kopiervorgängen.

Beim vorstehend beschriebenen Beispiel gehen die Saugrahmen 13 auf der jeweils zugeordneten Längsführungsbahn 20 reversierend von außen nach innen und zurück. Die Rahmenhalter 18 sind dementsprechend in Längsrichtung der Längsführungsbahnen 20 stationär angeordnet und werden lediglich entlang ihrer Vertikalführungen 19 vertikal bewegt.

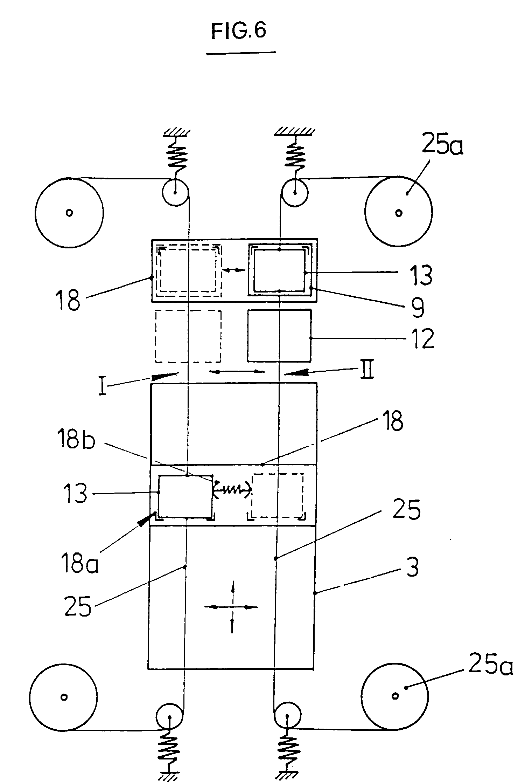

Der Figur 6 liegt wiederum eine Ausführung mit reversierender Saugrahmenbewegung zugrunde. Für gleiche Teile finden daher gleiche Bezugszeichen wie bei der Ausführung gemäß Figuren 1 bis 5 Verwendung. Der in x- und y-Richtung bewegbare Plattentisch 3 ist hier von einem über seine ganze Breite durchgehenden, in x- und y-Richtung stationären Rahmenhalter 18 übergriffen, der zwei nebeneinander sich befindende Rahmenaufnahmeeinrichtungen 18a aufweist, in denen jeweils ein Saugrahmen 13 aufgenommen werden kann. Im dargestellten Beispiel ist die linke Rahmenaufnahmeeinrichtung 18a mit einem Saugrahmen 13 besetzt. Die rechte Rahmenaufnahmeeinrichtung ist leer. Im Bereich der vorderen Tischstirnseite ist ein weiterer, mit dem ihm gegenüberliegenden, tischseitigen Rahmenhalter 18 identischer Rahmenhalter 18 vorgesehen, dessen rechte Rahmenaufnahmeeinrichtung momentan mit einem Saugrahmen 13 besetzt und dessen linke Rahmenaufnahmeeinrichtung leer ist. Der äußere Rahmenhalter 18 übergreift eine Filmkassette 9. Die registerhaltige Positionierung der Saugrahmen 13 in den Rahmenhaltern 18 kann unter Druck gegen Anschläge erfolgen.

Die beiden, im Wechsel in den tischseitigen bzw. äußeren Rahmenhalter 18 einfahrbaren Saugrahmen 13 sind an parallelen Zugmitteln 25, hier in Form von Drahtseilen etc., angehängt, und durch diese entlang parallel nebeneinander sich befindender Rahmenfahrstraßen I, II bewegbar, denen Führungsbahnen in Form von Führungsschienen zugeordnet sein können. Im dargestellten Ausführungsbeispiel sind keine Führungsbahnen vorgesehen, so daß die Zugmittel 25 gleichzeitig als Tragmittel ausgebildet sind. Die im Bereich der Rahmenhalter 18 und zwischen diesen parallel nebeneinander verlaufenden Zugmittel 25 sind über die beiden Rahmenhalter 18 hinweggeführt und anschließend umgelenkt und mit ihren Enden an Aufwickeltrommeln 25a befestigt. Die in Bewegungsrichtung jeweils vordere Aufwickeltrommel 25a wird angetrieben, die hintere abgebremst.

Zur Erzeugung einer satten in Laufrichtung gehenden Anlage der Saugrahmen 13 an zugeordneten rahmenhalterseitigen Anschlägen unter Druck können die Zugmittel 25 mit Federn versehen oder abgefe-dert sein. Quer hierzu können federnde Andrücker 18b vorgesehen sein, die zum Eingriff mit einer Rahmenkante kommen.

Bei Verwendung von Führungsschienen kann dadurch bereits quer zur Fahrtrichtung eine exakte formschlüssige Positionierung erreicht werden.

Die vom äußeren Rahmenhalter 18 übergriffene Filmkassette 9 ist um den Abstand der rahmenhalterseitigen Rahmenaufnahmeeinrichtungen 18a hin- und herbewegbar, so daß nur eine Filmkassette 9 benötigt wird, aus welcher der jeweils in den Rahmenhalter 18 eingefahrene Saugrahmen einen neuen Film entnehmen kann und dennoch ein gerader Verlauf der Zugmittel 25 und gegebenenfalls der Führungsbahnen möglich ist. Dementsprechend befindet sich die Filmkassette 9 im dargestellten Ausführungsbeispiel in ihrer linken Position unterhalb des in den äußeren Rahmenhalter 18 eingefahrenen Saugrahmen 13. Der Filmkassette 9 vorgeordnet ist eine Leerkassette 12, in welche der jeweils kopierte Film vom darüber hinwegfahrenden Saugrahmen 13 abgeworfen werden kann. Die Leerkassette 12 ist wie die Filmkassette 9 hin- und herbewegbar, so daß man auch mit einer Leerkassette auskommt. Im dargestellten Ausführungsbeispiel befindet sich die Leerkassette ebenfalls in ihrer rechten Position, so daß der vorher über sie hinweggefahrene, rechte Saugrahmen 13 den zuvor kopierten Film abwerfen konnte.

Nachdem der rechte Saugrahmen 13 einen neuen Film aufgenommen hat, fahren die Filmkassette 9 und die Leerkassette 12 in die linke Position, wie durch gestrichelte Linien angedeutet ist. Ebenso sind die nicht besetzten Rahmenaufnahmeeinrichtungen durch gestrichelte Linien angedeutet. Beim darauffolgenden Wechsel der Saugrahmen, das heißt beim Ausfahren des linken Saugrahmens 13 aus der Kopierstation, kann der linke Saugrahmen 13 den vorher kopierten Film abwerfen und einen neuen Film aufnehmen.

Es wäre aber auch denkbar zwei nebeneinander angeordnete Filmkassetten vorzusehen, von denen jede die halbe Füllung hat. In diesem Fall entfällt die hin- und hergehende Kassettenbewegung. Dasselbe gilt für die Leerkassette. Ebenso wäre es denkbar, lediglich eine zweckmäßig in einer Mittelstellung fixierte Filmkassette 9 bzw. Leerkassette 12 vorzusehen und die Saugrahmen 13 etwa mittels gebogener Führungsschienen entsprechend zu führen. Der kassettenseitige Rahmenhalter benötigt dabei nur eine Rahmenaufnahmeeinrichtung 18a.

Die Filmkassette 9 ist zusätzlich auf- und abbewegbar, so daß hierdurch ein Eingriff mit dem im äußeren Rahmenhalter 18 aufgenommenen Saugrahmen 13 hergestellt werden kann. Der äußere Rahmehalter 18 kann dementsprechend auch in z-Richtung stationär angeordnet sein. Der tischseitige, in x- und y-Richtung stationäre Rahmenhalter 18 ist in z-Richtung soweit bewegbar, daß der jeweils eingefahrene Saugrahmen 13 zum Eingriff mit dem auf dem Plattentisch 3 aufgenommenen Plattenrohling gebracht werden kann.

Zum Belichten des Films ist eine den Plattentisch 3 übergreifende, hier nicht näher dargestellte Belichtungseinrichtung vorgesehen. Diese kann entweder zwei den beiden, nebeneinander angeordneten Rahmenaufnahmeeinrichtungen 18a des tischseitigen Rahmenhalters zugeordnete Belichtungsköpfe oder einen um den entsprechenden Abstand der beiden Rahmenaufnahmeeinrichtungen 18a hin- und herbewegbaren Belichtungskopf aufweisen.

Anstelle nebeneinander hin- und herfahrender Saugrahmen könnten auch hintereinander angeordnete Saugrahmen vorgesehen sein, die miteinander verbunden sein können. Diesen müßten ebenfalls zwei Filmkassetten oder eine in die beiden Entnahmepositionen bewegbare Filmkassette zugeordnet sein. Anstelle von Filmkassetten können natürlich in jeden Fall, das heißt auch bei den anderen Beispielen, als Filmaufnahmeeinrichtungen Ablageplattformen mit kassettenähnlichen Registrierungsorganen und diesen zugeordnete aus einer Kassette bedienbare Zubringer zugeordnet sein.

## Patentansprüche

1. Vorrichtung zur Herstellung von Druckplatten mit einer einen Plattentisch (3) und eine diesem zugeordnete Belichtungseinrichtung (5) aufweisenden Kopierstation(1), der wenigstens eine vorzugsweise durch eine Filmkassette (9) gebildete Filmaufnahmeeinrichtung für unkopierte Filme und vorzugsweise wenigstens eine Leerkassette (12) für kopierte Filme zugeordnet sind, wobei jeweils der auf einen Plattenrohling (2) zu kopierende Film mittels eines bewegbaren Saugrahmens(13) von einer Filmaufnahmeeinrichtung (Filmkassette 9) entnehmbar, an dem auf dem Plattentisch (3) aufnehmbaren Plattenrohling (2) in Anlage bringbar und nach erfolgter Belichtung vorzugsweise an eine Leerkassette (12) abgebbar ist, **dadurch gekennzeichnet, daß** mehrere Saugrahmen (13) vorgesehen sind, die auf jeweils zugeordnet, quer zur Belichtungsachse der Belichtungseinrichtung (5) verlaufenden Führungsbahnen (20), die zwischen der außerhalb des Plattentisches (3) angeordneten, bezüglich des Plattentisches (3) abstandsfesten Filmaufnahmeeinrichtung für unkopierte Filme und dem Plattentisch (3) verlaufen, reversierend verfahrbar sind, und daß die Arbeitskreisläufe der Saugrahmen (13) so gegeneinander phasenverschoben sind, daß abwechselnd jeweils ein Saugrahmen (13) in die zugeordneten Filmaufnahmeeinrichtung für unkopierte Filme und ein anderer Saugrahmen (13) in der Kopierstation(1) befinden.

2. Vorrichtung nach Anspruch 1, **dadurch gekennzeichnet, daß** im Bereich der Filmaufnahmeeinrichtung für unkopierte Filme und des Plattentisches (3) mit dem jeweils ankommenden Saugrahmen (13) zum Eingriff bringbare Registrierorgane (24) vorgesehen und die Saugrahmen (13) im mit den Registrierungsorganen (24) zusammenwirkenden Zustand in Wirkverbindung mit der Filmaufnahmeeinrichtung für unkopierte Filme bzw. dem Plattentisch (3) bringbar sind, wobei der Filmaufnahmeeinrichtung und dem Plattentisch (3) jeweils ein mit Saugrahmen-Positionierungseinrichtungen versehener Rahmenhalter (18) zugeordnet ist, in welchen der jeweils ankommende Saugrahmen (13) registerhaltig einbringbar ist, der in der in den betreffenden Rahmenhalter (18) eingefahrenen Stellung in Wirkverbindung mit der zugeordneten Filmaufnahmeeinrichtung bzw. dem Plattentisch (3) bringbar ist.

3. Vorrichtung nach einem der vorhergehenden Ansprüche, **dadurch gekennzeichnet, daß** zwei Saugrahmen (13) mit zugeordneten Führungsbahnen (20) vorgesehen sind.

4. Vorrichtung nach Anspruch 2 oder 3, **dadurch gekennzeichnet, daß** die Führungsbahnen (20), die im Bereich der einander gegenüberliegenden Flanken der Rahmenhalter (18) enden, durch Schienen gebildet werden, welche dasselbe Führungsprofil wie die Rahmenhalter (18) aufweisen.

5. Vorrichtung nach einem der vorhergehenden Ansprüche, **dadurch gekennzeichen, daß** die parallel zur Belichtungsachse der Belichtungseinrichtung (5) verfahrbaren Rahmenhalter (18) durch quer zu den Führungsbahnen (20) verlaufende Führungen (19) geführt sind.

6. Vorrichtung nach einem der vorhergehenden Ansprüche, **dadurch gekennzeichnet, daß** die im Bereich der inneren und äußeren Enden der Führungsbahnen (20) vorgesehenen Rahmenhalter (18) zumindest um den Abstand der benachbarten, deckend übereinander angeordneten Führungsbahnen (20) verfahrbar sind.

7. Vorrichtung nach Anspruch 6, **dadurch gekennzeichnet, daß** der innere, dem Plattentisch (3) zugeordnete Rahmenhalter (18) zwischen den Führungsbahnen (20) verfahrbar und von jeder Führungsbahn (20) aus bis auf den Plattentisch (3), der in Vertikalrichtung stationär angeordnet und parallel zur Tischfläche einstellbar ist, absenkbar ist.

8. Vorrichtung nach Anspruch 6 oder 7, **dadurch gekennzeichnet, daß** der äußere, der Filmkassettenanordnung zugeordnete Rahmenhalter (18) nur zwischen den Führungsbahnen (20) verfahrbar ist und daß die unterhalb der untersten Führungsbahn (20) vorgesehene Aufnahmeeinrichtung für unkopierte Filme heb- und senkbar angeordnet und durch Anheben mit dem in den zugeordneten Rahmenhalter (18) eingefahrenen Saugrahmen (13) in Wirkverbindung bringbar ist.

9. Vorrichtung nach einem der vorhergehenden Ansprüche, **dadurch gekennzeichnet, daß** eine Aufnahmeeinrichtung für unkopierte Filme, die von allen Saugrahmen (13) anfahrbar ist, vorgesehen ist.

10. Vorrichtung nach einem der vorhergehenden Ansprüche, **dadurch gekennzeichnet, daß** eine der Anzahl der Führungsbahnen (20) entsprechende Anzahl von diesen zugeordneten, unterhalb hiervon angeordneten Leerkassetten (12) vorgesehen ist.

11. Vorrichtung nach einem der vorhergehenden Ansprüche, **dadurch gekennzeichnet, daß** den Führungsbahnen (20) gegenläufig antreibbare, mit dem jeweils zugeordneten Saugrahmen (13) kuppelbare Schleppeinrichtungen (25) zugeordnet sind.

12. Vorrichtung nach Anspruch 11, **dadurch gekennzeichnet, daß** im Falle von zwei auf gegeneinander versetzten Führungsbahnen (20) aufnehmbaren Saugrahmen (13) die diesen zugeordneten Schleppeinrichtungen (25) als Ober- und Untertrum eines endlosen Zugorgans (29) ausgebildet sind, das reversierend antreibbar ist.

13. Vorrichtung nach Anspruch 11 oder 12, **dadurch gekennzeichnet, daß** die Schleppeinrichtungen (25) mit jeweils einem Mitnehmer (26) versehen sind, mit dem ein Gegenhalter (27) des jeweils zugeordneten Saugrahmens (13) quer zur Führungsbahnebene in und außer Eingriff bringbar ist.

14. Vorrichtung nach einem der vorhergehenden Ansprüche 1 bis 5, **dadurch gekennzeichnet, daß** den Saugrahmen (13) zugeordnete, zumindest im Bereich des Plattentisches (3) auf gleicher Höhe verlaufende Rahmenfahrstraßen (I, II) vorgesehen sind und daß jeder dem Ende nebeneinander verlaufender Rahmenfahrstraßen benachbarte Rahmenhalter (18) mehrere, jeweils einer Rahmenfahrstraße zugeordnete Rahmenaufnahmeeinrichtungen (18a) aufweist.

15. Vorrichtung nach Anspruch 14, **dadurch gekennzeichnet, daß** eine Filmkassette (9) vorgesehen ist, die von jedem Saugrahmen (13) anfahrbar ist und die um den Abstand der benachbarten Rahmenfahrstraßen seitlich verfahrbar ist.

16. Vorrichtung nach Anspruch 14 oder 15, **dadurch gekennzeichnet, daß** eine Leerkassette (12) vorgesehen ist, die unterhalb der Rahmenfahrstraßen angeordnet und zwischen diesen verfahrbar ist.

## Claims

1. Apparatus for making printing plates with a copying station (1) comprising a plate table (3) and an exposure device (5) associated therewith, said copying station operating in conjunction with at least one film holder for uncopied films, preferably formed by a film cassette (9), and preferably at least one empty cassette (12) for copied films, in which each film to be copied on to a blank plate (2) can, by means of a traversable suction frame (13), be removed from a film holder for uncopied films, be laid on the blank plate (2) held on the plate table (3) and, after exposure, preferably be discharged to an empty cassette (12), characterized in that two or more suction frames (13) are provided, which are reversibly traversable on separate guideways (20) extending at right angles to the exposure axis of the exposure device (5) and between the plate table (3) and the film holder for uncopied films, located away from the plate table (3) at a fixed distance therefrom, and in that the working cycles of the suction frames (13) are in phase opposition so that, in alternation, as one suction frame (13) arrives at the associated film holder for uncopied films another suction frame (13) arrives at the copying station (1).

2. Apparatus according to Claim 1, characterized in that, in the region of the film holder for uncopied films and in the region of the plate table (3), registering elements (24) engageable with the respective incoming suction frame (13) are provided and the suction frames (13) when cooperative with the registering elements (24) are able to be brought into operative connection with the film holder for uncopied films and with the plate table (3) respectively, the film holder and the plate table (3) each working in conjunction with a frame holder (18) provided with suction frame positioning devices allowing the incoming suction frame (13) to be brought into register with the corresponding frame holder (18) and, once inserted into the said frame holder, to be brought into operative connection with the associated film holder or plate table (3) as the case may be.

3. Apparatus according to either of the preceding claims,. characterized in that two suction frames (13) with separate guideways (20) are provided.

4. Apparatus according to Claim 2 or Claim 3, characterized in that the guideways (20), which terminate in the region of the opposing lateral faces of the frame holders (18), are formed by rails with the same guide profile as the frame holders (18).

5. Apparatus according to any one of the preceding claims, characterized in that the frame holders (18), which are traversable parallel with the exposure axis of the exposure device (5), are guided by guides (19) extending at right angles to the guideways (20).

6. Apparatus according to any one of the preceding claims, characterized in that the frame holders (18) provided in the region of the inner and outer ends of the guideways (20) are traversable over a distance at least equal to that which separates the guideways (20) arranged one directly above the other in the vertical plane.

7. Apparatus according to Claim 6, characterized in that the inner frame holder (18) cooperating with the plate table (3) is traversable between the guideways (20) and can be lowered from any guideway (20) to the plate table (3), which is fixed in the vertical direction and adjustable in the plane parallel with the surface of the table.

8. Apparatus according to Claim 6 or Claim 7, characterized in that the outer frame holder (18) cooperating with the film cassette arrangement is traversable between the guideways (20) only, and in that the holder for uncopied films provided underneath the lowermost guideway (20) is capable of being raised and lowered, and can be raised to bring it into operative connection with the suction frame (13) inserted in the associated frame holder (18).

9. Apparatus according to any one of the preceding claims, characterized in that a holder for uncopied films is provided which is approachable by all suction frames (13).

10. Apparatus according to any one of the preceding claims, characterized in that an equal number of empty cassettes (12) to the number of guideways (20) are provided, arranged underneath the guideways.

11. Apparatus according to any one of the preceding claims, characterized in that transfer devices (25), which can be coupled to the corresponding suction frame (13), and driven in both directions, are assigned to the guideways (20).

12. Apparatus according to Claim 11, characterized in that, in the case where two suction frames (13) are mountable on [vertically] offset guideways (20), the transfer devices (25) cooperating therewith are arranged as the top and bottom strands of an endless drag element (29) capable of being driven in both directions.

13. Apparatus according to Claim 11 or Claim 12, characterized in that the transfer devices (25) are each provided with a dog (26) with which a catch arm (27) on the associated suction frame (13) can be brought into and out of engagement, at right angles to the plane of the guideway.

14. Apparatus according to any one of the preceding Claims 1 to 5, characterized in that frame paths (I, II) which are on the same level at least in the region of the plate table (3) are assigned to the suction frames (13) and in that each frame holder (18) adjacent to the end of frame paths extending side by side has a plurality of frame holder arrangements (18a) each assigned to an individual frame path.

15. Apparatus according to Claim 14, characterized in that a film cassette (9) is provided which is approachable by every suction frame and laterally traversable over the distance between the adjacent frame paths.

16. Apparatus according to Claim 14 or Claim 15, characterized in that an empty cassette (12) is provided, located underneath the frame paths and traversable between them.

## Revendications

1. Dispositif de fabrication de plaques d'impression, avec un poste de copiage (1) présentant un plateau porte-plaque (3) et un appareil d'exposition (5) associé à ce plateau, poste auquel sont associés au moins un dispositif récepteur de film, formé de préférence par une cassette de film (9), pour des films non copiés et, de préférence, au moins une cassette vide (12) pour des films copiés, le film respectif à copier sur une plaque brute (2) pouvant être prélevé du dispositif récepteur de films non copiés au moyen d'un cadre aspirant mobile (13), amené en application contre la plaque brute (2) reçue sur le plateau porte-plaque (3) et, une fois l'exposition effectuée, délivré de préférence à une cassette vide (12), **caractérisé** en ce que plusieurs cadres aspirants (13) sont prévus, qui peuvent être déplacés en navette sur des glissières (20) respectivement associées, s'étendant transversalement à l'axe d'exposition de l'appareil d'exposition (5), qui s'étendent entre le plateau porte-plaque (3) et le dispositif récepteur de films non copiés, disposé en dehors du plateau porte-plaque (3) à distance fixe de ce dernier, et en ce que les circuits de travail des cadres aspirants (13) sont mutuellement déphasés de telle sorte qu'alternativement, chaque fois, un cadre aspirant (13) entre dans le dispositif récepteur associé de films non copiés, et un autre cadre aspirant (13) entre dans le poste de copiage (1).

2. Dispositif selon la revendication 1, **caractérisé** en ce que des organes enregistreurs (24) sont prévus dans la région du dispositif récepteur de films non copiés et du plateau porte-plaque (3), organes qui peuvent être amenés en engagement avec le cadre aspirant (13) respectivement arrivant, et les cadres aspirants (13) pouvant être amenés, dans l'état de coopération avec les organes enregistreurs (24), en liaison fonctionnelle avec le dispositif récepteur de films non copiés ou, respectivement, le plateau porte-plaque (3), un support de cadre respectif (18), pourvu d'organes de positionnement de cadre aspirant, étant associé au dispositif récepteur de film et au plateau porte-plaque (3), le cadre aspirant (13) respectivement arrivant pouvant être introduit avec un repérage point sur point dans ce support de cadre, ledit cadre aspirant (13) pouvant, dans la position rentrée dans le support de cadre (18) concerné, être amené en liaison fonctionnelle avec le dispositif récepteur de film associé ou, respectivement, le plateau porte-plaque (3).

3. Dispositif selon une des revendications précédentes, **caractérisé** en ce que deux cadres aspirants (13) sont prévus, avec des glissières (20) associées.

4. Dispositif selon la revendication 2 ou 3, **caractérisé** en ce que les glissières (20), qui se terminent dans la région des flancs mutuellement opposés des supports de cadre (18), sont formés par des profilés qui présentent le même profil de guidage que les supports de cadre (18).

5. Dispositif selon une des revendications précédentes, **caractérisé** en ce que les supports de cadre (18), qui peuvent être déplacés parallèlement à l'axe d'exposition de l'appareil d'exposition (5), sont guidés par des guidages (19) s'étendant transversalement aux glissières (20).

6. Dispositif selon une des revendications précédentes, **caractérisé** en ce que les supports de cadre (18), prévus dans la région des extrémités intérieures et extérieures des glissières (20), peuvent être déplacés au moins de la distance entre les glissières (20) voisines, superposées en coïncidence.

7. Dispositif selon la revendication 6, **caractérisé** en ce que le support de cadre (18) intérieur, associé au plateau porte-plaque (3), peut être déplacé entre les glissières (20) et peut être, depuis chaque glissière (20), abaissé jusque sur le plateau porte-plaque (3), qui est disposé stationnairement en direction verticale et qui peut être réglé parallèlement à la surface du plateau.

8. Dispositif selon la revendication 6 ou 7, **caractérisé** en ce que le support de cadre (18) extérieur, associé à l'ensemble de cassette de film, peut seulement être déplacé entre les glissières (20), et en ce que le dispositif récepteur de films non copiés, prévu en dessous de la glissière (20) la plus basse, est disposé avec possibilité de levage et d'abaissement et peut, en le levant, être amené en liaison fonctionnelle avec le cadre aspirant (13) introduit dans le support de cadre (18) associé.

9. Dispositif selon une des revendications précédentes, **caractérisé** en ce qu'on a prévu un dispositif récepteur de films non copiés qui peut être atteint par tous les cadres aspirants (13).

10. Dispositif selon une des revendications précédentes, **caractérisé** en ce qu'on a prévu un nombre, correspondant au nombre de glissières (20), de cassettes vides (12) associées à ces glissières et disposées en dessous d'elles.

11. Dispositif selon une des revendications précédentes, **caractérisé** en ce que des organes remorqueurs (25) sont associés aux glissières (20), organes qui peuvent être entraînés en sens contraire et qui peuvent être accouplés au cadre aspirant (13) respectivement associé.

12. Dispositif selon la revendication 11, **caractérisé** en ce que, dans le cas de deux cadres aspirants (13) pouvant être reçus sur des glissières (20) mutuellement décalées, les organes remorqueurs (25) qui leur sont associés sont réalisés sous la forme du tronçon supérieur et du tronçon inférieur d'un organe de traction sans fin (29), qui peut être entraîné de façon réversible.

13. Dispositif selon la revendication 11 ou 12, **caractérisé** en ce que les organes remorqueurs (25) sont pourvus d'un entraîneur respectif (26), avec lequel peut être amené en et hors d'engagement, transversalement au plan de la glissière, un élément de contre-appui (27) du cadre aspirant (13) respectivement associé.

14. Dispositif selon une des revendications précédentes 1 à 5, **caractérisé** en ce que des voies de déplacement de cadre (I, II) associées aux cadres aspirants (13) sont prévues, voies qui s'étendent à la même hauteur au moins dans la région du plateau porte-plaque (3), et en ce que chaque support de cadre (18) voisin de l'extrémité de voies de déplacement de cadre s'étendant côte à côte présente plusieurs dispositifs récepteurs de cadre (18a), respectivement associés à une voie de déplacement de cadre.

15. Dispositif selon la revendication 14, **caractérisé** en ce qu'on a prévu une cassette de film (9) qui peut être atteinte par chaque cadre aspirant (13) et qui peut être déplacée latéralement de la distance entre les voies de déplacement de cadre voisines.

16. Dispositif selon la revendication 14 ou 15, **caractérisé** en ce qu'on a prévu une cassette vide (12) qui est disposée en dessous des voies de déplacement de cadre et qui peut être déplacée entre ces dernières.
